(19) Europäisches Patentamt

European Patent Office

Office européen des brevets

(11) **EP 0 715 401 B1**

(12) **FASCICULE DE BREVET EUROPEEN**

(45) Date de publication et mention
de la délivrance du brevet:
**04.10.2001 Bulletin 2001/40**

(51) Int Cl.⁷: **H03B 21/02**

(21) Numéro de dépôt: **95203190.4**

(22) Date de dépôt: **21.11.1995**

(54) **Dispositif diviseur de fréquence**

Frequenzteiler

Frequency divider

(84) Etats contractants désignés:
**DE FR GB**

(30) Priorité: **30.11.1994 FR 9414374**

(43) Date de publication de la demande:
**05.06.1996 Bulletin 1996/23**

(73) Titulaire: **Koninklijke Philips Electronics N.V.**
**5621 BA Eindhoven (NL)**

(72) Inventeur: **Marchand, Philippe,**
**Société Civile S.P.I.D.**
**F-75008 Paris (FR)**

(74) Mandataire: **Chaffraix, Jean et al**
**Société Civile S.P.I.D.**
**156, Boulevard Haussmann**
**75008 Paris (FR)**

(56) Documents cités:
**US-A- 4 725 786**

- **INTERNATIONAL MICROWAVE SYMPOSIUM DIGEST (MTT-S), ALBUQUERQUE, JUNE 1 - 5, 1992, vol. 2, 1 Juin 1992, REID D W, pages 695-697, XP002000059 NUECHTER P ET AL: "A MM-WAVE FREQUENCY DIVIDER"**
- **PROCEEDINGS OF THE MM (MILLIMETRE) CONFERENCE, BRIGHTON, OCT. 14 - 15, 1992, no. CONF. 9, 14 Octobre 1992, MICROWAVE EXHIBITIONS AND PUBLISHERS, pages 99-103, XP002000060 HUNTER I C ET AL: "DEVELOPMENTS IN COMPONENT TECHNOLOGY FOR 60 GHZ RADIO LINKS"**
- **REVIEW OR SCIENTIFIC INSTRUMENTS, vol. 57, no. 10, Octobre 1986, , NEW YORK, USA, XP002000061 VAN ARDENNE, WOESTENBURG, VAN DER REE:: "350-Ghz phase/frequency locked loop for use with a carcinotron backward wave oscillator"**

**Description**

La présente invention concerne un dispositif diviseur de fréquence comportant une borne d'entrée pour un signal à diviser et une borne de sortie pour un signal de fréquence moindre dont la fréquence est égale à une partie de la fréquence du signal à diviser.

Le dispositif trouve d'importantes applications surtout dans le domaine des fréquences élevées, par exemple de l'ordre de la centaine de gigahertz.

Dans le brevet USP No.4,725,786 il est décrit un dispositif qui modifie des fréquences d'entrée en d'autres fréquences de sortie. Ce dispositif connu n'est pas apte à modifier des fréquences élevées et ne se comporte pas comme un diviseur de fréquence.

La présente invention propose un dispositif diviseur de fréquence qui est apte à diviser des fréquences élevées et dont la fréquence de sortie dépend uniquement de la fréquence d'entrée.

Pour cela un tel dispositif est remarquable en ce qu'il comporte :

- un premier mélangeur, qui est notamment du type sous-harmonique, muni d'une première entrée qui constitue la borne d'entrée, d'une deuxième entrée pour recevoir un signal d'un oscillateur local,
- un premier circuit diviseur pour diviser le signal de sortie du premier mélangeur,
- un deuxième circuit diviseur pour diviser le signal de sortie de l'oscillateur local,
- un deuxième circuit mélangeur muni d'une première entrée pour recevoir le signal de sortie du premier circuit diviseur, d'une seconde entrée pour recevoir le signal de sortie du deuxième circuit diviseur et d'une sortie qui constitue la borne de sortie.

La description suivante, faite en regard des dessins ci-annexés, le tout donné à titre d'exemple non limitatif, fera bien comprendre comment l'invention peut être réalisée.

La figure 1 montre le dispositif diviseur conforme à l'invention.
La figure 2 montre un circuit d'asservissement de fréquence utilisant le dispositif diviseur conforme à l'invention.

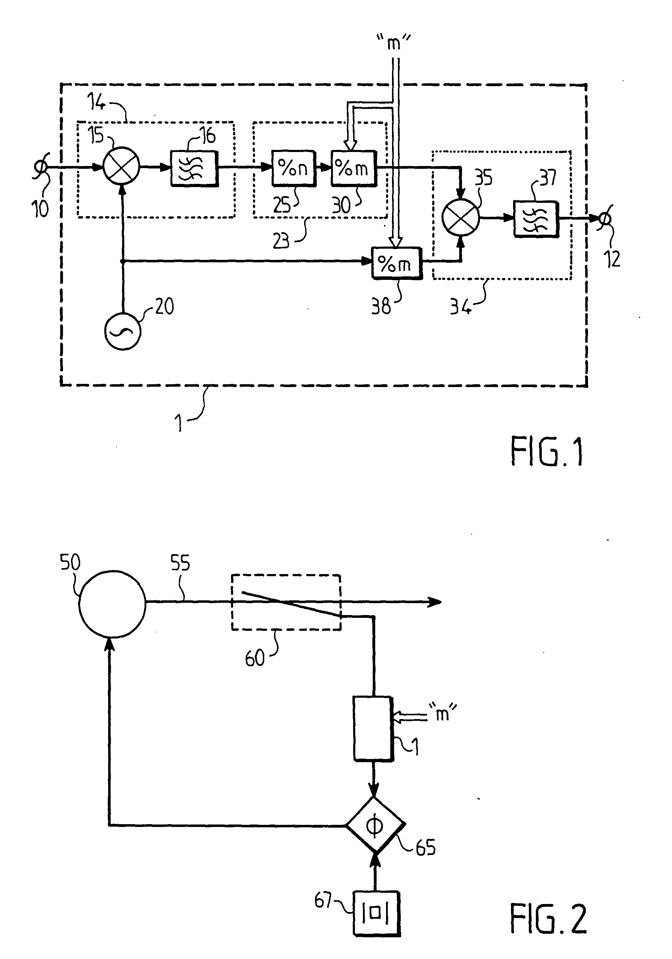

Le dispositif de l'invention porte la référence 1 à la figure 1. Il est muni d'une borne d'entrée 10 à laquelle est appliqué un signal de haute fréquence dont la valeur est, par exemple, F = 108 GHz. A une borne de sortie 12, apparaît un signal dont la fréquence FS a une valeur "k" fois moindre. Pour diviser la fréquence d'un tel signal, il n'est pas possible d'employer des diviseurs de fréquences de type numérique, même fabriqué en technologie rapide.

Pour obtenir cette division, conformément à l'invention, on utilise un premier mélangeur 14 du type sous-harmonique dont une première entrée est reliée à la borne 10 et qui fournit à sa sortie un signal de fréquence : $F - p.f_o$ où :

- $f_o$ est la fréquence d'un oscillateur local 20 dont la sortie est reliée à une deuxième entrée du circuit mélangeur 14 et
- p est un nombre entier définissant le rang du mélangeur sous-harmonique.

Ce mélangeur 14 du type sous-harmonique est schématisé sur la figure par un circuit mélangeur 15, suivi d'un filtre passe-bande 16. On trouvera une description d'un mélangeur sous-harmonique dans l'article suivant :

"Harmonically Pumped Stripline Down-Converter" de Martin V. Schneider et William W. Snell, Jr., paru dans la revue :

IEEE TRANSACTIONS ON MICROWAVE THEORY AND TECHNIQUES, vol.MTT-23, n°3, de mars 1975, pages 271 à 275.

Comme maintenant la fréquence a été abaissée, il est possible d'utiliser des circuits diviseurs de type numérique mais de vitesse de fonctionnement relativement élevée. Un premier circuit diviseur 23 formé par des circuits de division 25 et 30 qui divisent respectivement par "n" et "m" la fréquence du signal de sortie du filtre 16. Le circuit de division 30 est un circuit diviseur programmable, ce qui permet de faire varier commodément la fréquence de sortie FS. Un deuxième circuit mélangeur 34 est formé d'un mélangeur 35 proprement dit et d'un filtre passe-bande 37. Une entrée de ce circuit 34 est reliée à la sortie du circuit de division 30 et une deuxième entrée est reliée à la sortie d'un deuxième circuit diviseur 38. Ce circuit 34 fournit un signal dont la fréquence est la somme des fréquences des signaux appliqués à ses entrées. L'entrée de ce deuxième circuit diviseur 38, de type programmable de préférence, est reliée à la sortie de l'oscillateur 20.

Pour résumer, la fréquence F1 du signal appliqué à la première entrée du mélangeur 34 est telle que :

$$F1 = \frac{F - p.f_o}{m.n}$$

la fréquence F2 du signal appliqué à la deuxième entrée du mélangeur est telle que :

$$F2 = \frac{f_o}{m}$$

La fréquence FS de sortie du diviseur s'écrit :

$$FS = F1 + F2 = \frac{F - p.f_o}{m.n} + \frac{f_o}{m} = \frac{F}{m.n} + f_o\left(\frac{1}{m} - \frac{p}{m.n}\right)$$

en choisissant n = p on obtient :

$$FS = \frac{F}{m.n} = \frac{F}{k}$$

Ainsi la fréquence de sortie FS ne dépend plus de la fréquence de l'oscillateur local.

Il est possible de faire varier la fréquence de sortie en agissant corrélativement sur les circuits diviseurs 30 et 38. A titre d'exemple :

F = 108 GHz.
$f_o$ = 10 GHz
p = n = 4

avec m = 16, la fréquence Fs = 1,6875 GHz.

La figure 2 montre un exemple d'application d'un tel dispositif diviseur 1. Ce dispositif permet d'asservir la fréquence d'un oscillateur à très haute fréquence du type carcinotron. Ce genre d'oscillateur permet une commande de fréquence en faisant varier une tension appliquée à une entrée de commande 51. L'onde hyperfréquence engendrée par cet oscillateur 50 est transmise par un guide d'onde 55 dans le parcours duquel est disposé un coupleur 60. Ce coupleur prélève une partie de l'onde émise et la transmet à l'entrée du dispositif 1 selon l'invention. La sortie du dispositif est reliée à une première entrée d'un détecteur de phase 65 qui reçoit sur une deuxième entrée le signal de sortie d'un oscillateur de référence constitué à partir d'un oscillateur à quartz 67. Le signal de comparaison de ce détecteur de phase est appliqué à l'entrée de commande 51.

**Revendications**

1. Dispositif diviseur de fréquence comportant une borne d'entrée (10) pour un signal à diviser et une borne de sortie (12) pour un signal de fréquence moindre dont la fréquence est égale à une partie de la fréquence du signal à diviser, **caractérisé en ce qu'**il comporte :

   - un premier mélangeur (14), qui est notamment du type sous-harmonique, muni d'une première entrée qui constitue la borne d'entrée, d'une deuxième entrée pour recevoir un signal d'un oscillateur local (20),
   - un premier circuit diviseur (23) pour diviser le signal de sortie du premier mélangeur,
   - un deuxième circuit diviseur (38) pour diviser le signal de sortie de l'oscillateur local,
   - un deuxième circuit mélangeur (34) muni d'une première entrée pour recevoir le signal de sortie du premier circuit diviseur et d'une seconde entrée pour recevoir le signal de sortie du deuxième circuit diviseur et d'une sortie qui constitue la borne de sortie,

et **en ce que** les taux de division des circuits diviseurs et la valeur du rang du mélangeur sous-harmonique sont choisis tels que la fréquence de sortie ne dépend plus de la valeur de la fréquence de l'oscillateur local.

2. Dispositif diviseur selon la revendication 1, **caractérisé en ce que** le rang du mélangeur sous-harmonique est égal à un facteur du taux de division du premier circuit diviseur (23) et **en ce que** le taux de division du deuxième circuit diviseur (38) est égal au taux de division du premier circuit diviseur, divisé par ledit facteur.

3. Synthétiseur de fréquence du type à verrouillage de phase comportant un oscillateur à commande de fréquence, un dispositif diviseur selon l'une des revendications 1 à 2, un détecteur de phase pour comparer les signaux de sortie du dispositif diviseur avec des signaux de référence provenant d'un oscillateur de référence et pour fournir des signaux de commande à ladite commande de fréquence.

**Patentansprüche**

1. Frequenzteiler mit einer Eingangsklemme (10) für ein zu teilendes Signal und einer Ausgangsklemme (12) für ein Signal einer darunter liegenden Frequenz, dessen Frequenz gleich einem Teil der Frequenz des zu teilenden Signals ist, **dadurch gekennzeichnet, daß** er enthält:

   - einen ersten Mischer (14), der insbesondere vom subharmonischen Typ ist, versehen mit einem ersten Eingang, der die Eingangsklemme bildet, einem zweiten Eingang, um ein Signal eines lokalen Oszillators (20) zu erhalten,
   - eine erste Teilerschaltung (23), um das Ausgangssignal des ersten Mischers zu teilen,
   - eine zweite Teilerschaltung (38), um das Ausgangssignal des lokalen Oszillators zu teilen,
   - eine zweite Mischerschaltung (34), versehen mit einem ersten Eingang, um das Ausgangssignal der ersten Teilerschaltung zu erhalten, einem zweiten Eingang, um das Ausgangssignal der zweiten Teilerschaltung zu erhalten, und einem Ausgang, der die Ausgangsklemme bildet,

und dadurch, **daß** die Teilungsverhältnisse und der Stellenwert des subharmonischen Mischers so gewählt werden, damit die Ausgangsfrequenz nicht mehr vom Frequenzwert des lokalen Oszillators abhängt.

**2.** Frequenzteiler nach Anspruch 1, **dadurch gekennzeichnet, daß** der Stellenwert des subharmonischen Mischers gleich einem Faktor des Teilungsverhältnisses der ersten Teilerschaltung (23) ist, und **daß** das Teilungsverhältnis der zweiten Teilerschaltung (38) gleich dem Teilungsverhältnis der ersten Teilerschaltung ist, geteilt durch den besagten Faktor.

**3.** Frequenzsynthetisierer vom Phasenverriegelungstyp mit einem frequenzsteuernden Oszillator, Frequenzteiler nach einem der Ansprüche 1 bis 2, Phasendetektor zum Vergleichen der Ausgangssignale des Frequenzteilers mit den aus einem Bezugsoszillator kommenden Bezugssignalen und zum Liefern der Steuersignale an die besagte Frequenzsteuerung.

**Claims**

**1.** A frequency divider comprising an input terminal (10) for a signal to be divided and an output terminal (12) for a signal of lower frequency, whose frequency is equal to part of the signal frequency to be divided, **characterized in that** it comprises:

- a first mixer, which (14) is particularly of the sub-harmonic type, has a first input that forms the input terminal, a second input for receiving a signal from a local oscillator (20),
- a first divider circuit (23) for dividing the output signal of the first mixer,
- a second divider circuit (38) for dividing the output signal of the local oscillator,
- a second mixer (34), which has a first input for receiving the output signal of the first divider circuit, a second input for receiving the output signal of the second divider circuit, and an output that forms the output terminal

and **in that** the dividing ratios of the divider circuits and the value of the rank of the sub-harmonic mixer are chosen so that the output frequency no longer depends on the value of the local oscillator frequency.

**2.** A divider as claimed in Claim 1, **characterized in that** the rank of the sub-harmonic mixer is equal to a factor of the dividing ratio of the first dividing circuit (23) and **in that** the dividing ratio of the second dividing circuit (38) is equal to the dividing ratio of the first dividing circuit, divided by said factor.

**3.** A frequency synthesizer of the phase locked type comprising a frequency control oscillator, a divider device as claimed in one of the Claims 1 to 2, a phase detector for comparing the output signals of the divider device with reference signals coming from a reference oscillator and for producing control signals for said frequency control.

FIG.1

FIG.2